(19) Europäisches Patentamt
European Patent Office
Office européen des brevets

(11) EP 2 704 209 B1

(12) EUROPEAN PATENT SPECIFICATION

(45) Date of publication and mention
of the grant of the patent:
**23.11.2016 Bulletin 2016/47**

(51) Int Cl.:
*H01L 31/042* *(2006.01)*   *H01L 31/0216* *(2006.01)*
*C08J 7/04* *(2006.01)*

(21) Application number: **12776993.3**

(22) Date of filing: **26.04.2012**

(86) International application number:
**PCT/KR2012/003216**

(87) International publication number:
**WO 2012/148176 (01.11.2012 Gazette 2012/44)**

(54) **BACK SHEET FOR SOLAR CELL MODULE AND SOLAR CELL MODULE INCLUDING SAME**

RÜCKSEITENFOLIE FÜR EIN SOLARZELLENMODUL UND SOLARZELLENMODUL DAMIT

COUCHE ARRIÈRE POUR MODULE DE CELLULES SOLAIRES ET MODULE DE CELLULES SOLAIRES L'UTILISANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.04.2011 KR 20110038894**
**25.04.2012 KR 20120043273**

(43) Date of publication of application:
**05.03.2014 Bulletin 2014/10**

(73) Proprietor: **Youl Chon Chemical Co. Ltd.**
**Seoul 156-709 (KR)**

(72) Inventors:
• **KANG, Han Jun**
**Suwon-si**
**Gyeonggi-do 440-725 (KR)**
• **YOON, Sung Hwan**
**Incheon 405-797 (KR)**
• **JEON, Seung Hwan**
**Ansan-si**
**Gyeonggi-do 425-021 (KR)**
• **LEE, Eun Goo**
**Seoul 152-055 (KR)**

(74) Representative: **Zacco Sweden AB**
**P.O. Box 5581**
**114 85 Stockholm (SE)**

(56) References cited:
EP-A1- 2 309 551         EP-A1- 2 631 956
WO-A1-2010/109898     WO-A1-2011/004872
KR-A- 20090 085 022     KR-A- 20090 121 273
KR-A- 20100 111 975     KR-A- 20110 030 857

## Description

[Technical Field]

The present disclosure relates to a back sheet for solar cell module and a solar cell module including same. More specifically, it relates to back sheet for a solar cell module that can be provided at low cost and has excellent adhesive property, moisture barrier property (moisture permeability preventing property), etc., and a solar cell module including same.

[Background Art]

Recently, solar cells developed as next-generation energy source are being rapidly spread for household and industrial purposes.

A solar cell module includes a plurality of solar cells. The solar cells are fixed by a filling sheet, and a back sheet is attached at least on a lower surface for the purpose of sealing and is modulated.

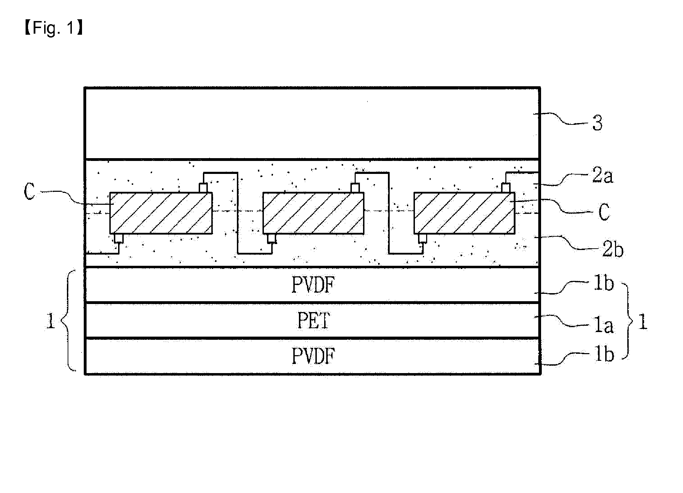

Fig. 1 schematically shows the configuration of a general solar cell module.

Referring to Fig. 1, a solar cell module generally has a structure wherein a reinforced glass 3 onto which light is incident, an upper filling sheet 2a, solar cells C, a lower filling sheet 2b and a back sheet 1 are stacked sequentially. Between the upper filling sheet 2a and the lower filling sheet 2b, a plurality of solar cells C are connected electrically and fixed. As for the upper/lower filling sheet 2a, 2b, an ethylene vinyl acetate (EVA) sheet which is advantageous in fixing the solar cells C is used.

A long lifetime with no deterioration of output over a long period of time is required for the solar cell module. To ensure long lifetime, it is important to isolate moisture or oxygen that negatively affects the solar cell C and prevent deterioration of the back sheet 1 due to hydrolysis or UV. Also, low cost of the back sheet 1 is strongly demanded by consumers recently. Accordingly, in order to ensure long lifetime of the solar cell module, the back sheet 1 has to be made of a material with good heat resistance, weather resistance, durability, etc. so that it can endure high temperature, humidity, UV, etc. well and needs to be available at low cost.

The back sheet 1 for a solar cell module generally has a structure in which a heat-resistant polyethylene terephthalate (PET) film as a base film is stacked with a weather-resistant fluorine-based film. That is to say, as shown in Fig. 1, the back sheet 1 generally includes a PET film 1 a and a fluorine-based film 1 b formed on the PET film 1 a. The fluorine-based film 1 b is attached to upper and lower surfaces of the PET film 1 a by an adhesive.

The PET film 1 a is useful as a base film of the back sheet 1 because is superior not only in heat resistance but also in mechanical strength. A polyvinylidene fluoride (PVDF) or polyvinyl fluoride (PVF) film is frequently used as the fluorine-based film 1b. The fluorine-based film 1b exhibits superior weather resistance and excellent hydrolysis resistance.

The existing back sheet 1 is prepared by attaching the fluorine-based film 1 b such as a PVDF or PVF film on the PET film 1a using an adhesive to improve weather resistance. However, since the fluorine-based film 1b such as PVDF or PVF film is expensive, it is not easy to lower the cost of the back sheet 1.

Further, the existing back sheet 1 is problematic in that, because of weak interlayer adhesion between the layers of the back sheet 1 and insufficient adhesion for modulation, durability and barrier properties such as moisture barrier property are unsatisfactory. Specifically, although the PET film 1 a and the fluorine-based film 1 b are bonded using an adhesive, the interlayer adhesion between the two films 1 a, 1 b is weak. Further, the back sheet 1 has to be tightly attached to the lower filling sheet 2b, i.e. the EVA sheet, of the solar cell module to ensure sealing. However, the adhesion between the fluorine-based film 1 b and the EVA sheet 2b is weak.

In addition, although the existing back sheet 1 is advantageous in heat resistance or weather resistance, it has poor barrier properties such as moisture barrier property because of high moisture permeability.

## [Disclosure of Invention]

[Technical Problem]

The present disclosure is directed to providing a back sheet for a solar cell module that can be provided at low cost and has excellent adhesive property and barrier properties (including moisture barrier property) and a solar cell module including the same.

[Solution to Problem]

In embodiments, there is provided a back sheet for solar cell module, including: a polyester film layer; and a fluorine coating layer coated on at least one surface of the polyester film layer.

In an exemplary embodiment, the back sheet may include: a polyester film layer; a fluorine coating layer coated on a lower surface of the polyester film layer; and a polyethylene-based film layer formed on an upper surface of the polyester film layer and attached to an ethylene vinyl acetate (EVA) sheet of a solar cell module.

Specifically, the polyethylene-based film layer may be white or may include an inorganic material. More specifically, it may include a white inorganic material. The white inorganic material may include titanium dioxide and may be included in an amount of 5-12 parts by weight.

In another embodiments, there is provided a solar cell module including the back sheet.

[Advantageous Effects of the Invention]

According to the embodiments of the present disclosure, a back sheet for a solar cell module having superior adhesive property and moisture barrier property (moisture permeability preventing property) may be provided at low cost.

[Brief Description of Drawings]

Fig. 1 schematically shows the configuration of a solar cell module and a back sheet according to the prior art.

Fig. 2 schematically shows the configuration of a back sheet for a solar cell module according to a first embodiment of the present disclosure.

Fig. 3 schematically shows the configuration of a back sheet for a solar cell module according to a second embodiment of the present disclosure.

Fig. 4 schematically shows the configuration of a back sheet for a solar cell module according to a third embodiment of the present disclosure.

Fig. 5 schematically shows the configuration of a back sheet for a solar cell module according to a fourth embodiment of the present disclosure.

Fig. 6 shows the configuration of an exemplary solar cell module according to an embodiment of the present disclosure, wherein the back sheet of Fig. 4 is used.

[Description of Numerals]

| | |
|---|---|
| 10: back sheet | 12: polyester film layer |
| 13: silicon oxide layer | 14: fluorine coating layer |
| 15: polyethylene-based film layer | 16: primer layer |
| 20: filling sheet | 30: transparent member |
| C: solar cell | |

[Mode for the Invention]

Hereinafter, the embodiments of the present disclosure are described in detail referring to the attached drawings.

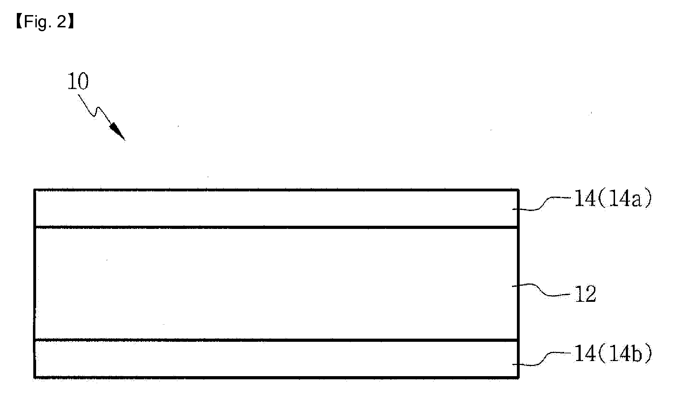

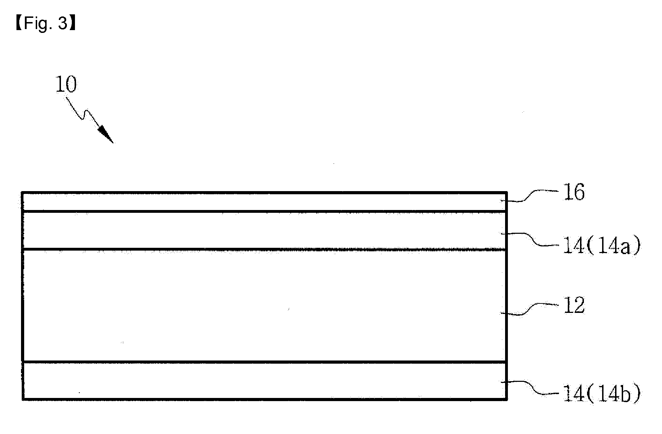

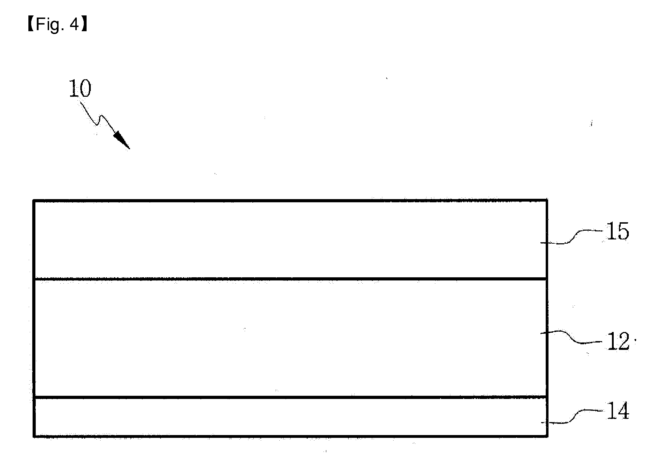

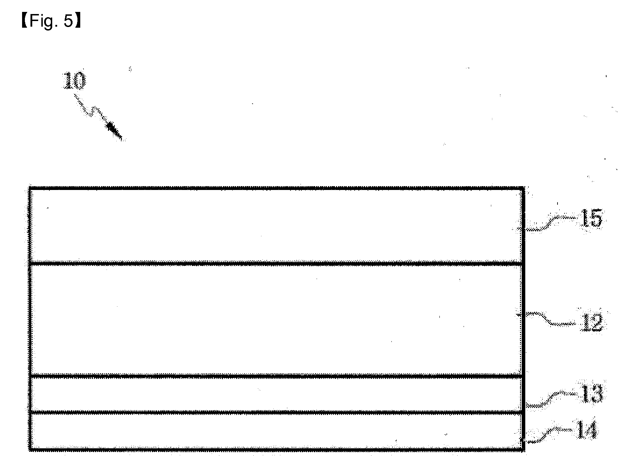

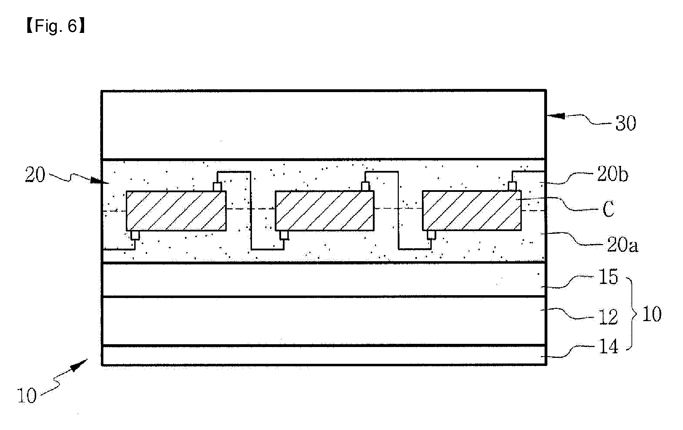

Fig. 2 schematically shows the configuration of a back sheet for a solar cell module according to a first embodiment of the present disclosure. Fig. 3 schematically shows the configuration of a back sheet for a solar cell module according to a second embodiment of the present disclosure. Fig. 4 schematically shows the configuration of a back sheet for a solar cell module according to a third embodiment of the present disclosure. Fig. 5 schematically shows the configuration of a back sheet for a solar cell module according to a fourth embodiment of the present disclosure. Fig. 6 shows the configuration of an exemplary solar cell module according to an embodiment of the present disclosure, wherein the back sheet of Fig. 4 is used.

As seen from Figs. 2-6, a back sheet for a solar cell module (hereinafter, "back sheet") according to the embodiments of the present disclosure uses a polyester film layer 12 as a base and includes a fluorine coating layer 14 for weather resistance, etc.

The fluorine coating layer 14 is formed by coating a fluorine resin composition on at least one surface of the polyester film layer 12. Specifically, the fluorine coating layer 14 may be formed on an upper surface 14a or a lower surface 14b of the polyester film layer 12, or on both the upper surface 14a and the lower surface 14b of the polyester film layer 12. Fig. 2 and Fig. 3 show examples wherein the fluorine coating layer 14 is formed on both the upper surface 14a and the lower surface 14b of the polyester film layer 12. Fig. 4 show an example wherein the fluorine coating layer 14 is formed on one surface, i.e. on the lower surface, of the polyester film layer 12.

Specifically, referring to Fig. 2 first, a back sheet 10 according to a first embodiment of the present disclosure has a stacked structure including: a polyester film layer 12; an upper fluorine coating layer 14a coated on an upper surface of the polyester film layer 12; and a lower fluorine coating layer 14b coated on a lower surface of the polyester film layer 12.

The polyester film layer 12 is formed of a polyester film. In the present disclosure, the polyester film may be formed from a polyester-based polymer polymerized from a compound having a carboxyl group and a compound having a hydroxyl group. Although not being particularly limited thereto, the polyester film may be selected from a polyethylene terephthalate (PET) film or a polyethylene naphthalate (PEN) film, which are advantageous in terms of heat resistance, mechanical strength, etc. Also, although not being particularly limited thereto, the polyester film layer 12 may have a thickness of 80-400 $\mu$m (micrometers), specifically 100-250 $\mu$m.

The fluorine coating layer 14 is used to improve weather resistance (UV barrier property, deterioration resistance, dimensional stability, etc.) and is formed by coating a fluorine resin composition on the polyester film layer 12. That is to say, in the embodiments of the present disclosure, the fluorine coating layer 14 is not formed by attaching a fluorine-based film 1 b (see Fig. 1) using an adhesive, as in the prior art, but is formed by coating a fluorine resin composition in liquid state on the polyester film layer 12 and then solidifying (hardening) it. Accordingly, according to the embodiments of the present disclosure, the cost of the back sheet 10 can be decreased and interlayer adhesion can be improved. That is to say, since the inexpensive fluorine resin composition in liquid state is coated to form the weather-resistant fluorine coating layer 14, instead of attaching the expensive fluorine-based film 1b (e.g., PVDF or PVF), the cost of the back sheet 10 can be reduced. In addition, the coating and hardening of the fluorine resin provide better interlayer adhesion between the polyester film layer 12 and the fluorine coating layer 14.

Specifically, the fluorine coating layer 14 may have a thickness of 5-30 $\mu$m. If the thickness of the fluorine coating layer 14 is smaller than 5 $\mu$m, the improvement of weather resistance, etc. by coating may be insufficient. And, if the thickness exceeds 30 $\mu$m, it may be difficult to reduce cost. When the fluorine coating layer 14 is coated with a thickness of 5-30 $\mu$m, the cost can be reduced, for example, by more than half as compared to when the existing fluorine-based film 1b such as PVDF or PVF is used. When considering weather resistance, cost, etc., the fluorine coating layer 14 have a thickness of more specifically 10-20 $\mu$m.

The fluorine coating layer 14 is formed by coating the fluorine resin composition. The fluorine resin composition may include a fluorine resin and a solvent as a diluent for improving coating performance. Specifically, the fluorine resin may be one having weather resistance and hydrolysis resistance etc. The fluorine resin is not particularly limited as long as it contains fluorine (F) in the molecule. For example, the fluorine resin may be one or more selected from polytetrafluoroethylene (PTFE), a perfluoroalkoxy (PFA) resin which is comprised of a copolymer of tetrafluoroethylene and perfluoroalkyl vinyl ether, a copolymer of tetrafluoroethylene and hexafluoropropylene, a copolymer of tetrafluoroethylene, and ethylene or propylene, polychlorotrifluoroethylene (PCTFE), polyvinylidene fluoride (PVDF), and polyvinyl fluoride (PVF), etc.

Further, the fluorine resin may be an ethylene-containing fluorine resin containing fluorine and ethylene in the molecule. For example, the ethylene-containing fluorine resin may be one or more selected from polytetrafluoroethylene (PTFE), a perfluoroalkoxy (PFA) resin which is comprised of a copolymer of tetrafluoroethylene and perfluoroalkyl vinyl ether, a copolymer of tetrafluoroethylene and hexafluoropropylene, a copolymer of tetrafluoroethylene, and ethylene or propylene, and polychlorotrifluoroethylene (PCTFE), etc.

The above-described ethylene-containing fluorine resins containing fluorine and ethylene in the molecule improve adhesive property together with weather resistance, and hydrolysis resistance, etc. Specifically, a filling sheet 20 (see Fig. 6) of the solar cell module may be formed of an ethylene vinyl acetate (EVA) sheet. Since the ethylene-containing fluorine resin contains ethylene which is a monomer constituting the ethylene vinyl acetate (EVA) sheet, adhesive property is improved at the side where it contacts with the ethylene vinyl acetate (EVA) sheet. That is to say, referring to Fig. 2, the upper fluorine coating layer 14a may be attached to the filling sheet 20 which is usually formed of ethylene vinyl acetate (EVA). If the upper fluorine coating layer 14a is formed of the above-described fluorine resin, it may be attached to the filling sheet 20 with high strength.

Also, as described above, the polyester film layer 12 may be formed of a polyethylene terephthalate (PET) film or a polyethylene naphthalate (PEN) film. Since the ethylene-containing fluorine resin contains ethylene which is one of the monomers constituting the polyethylene terephthalate (PET) film or the polyethylene naphthalate (PEN) film, adhesive property with the polyester film layer 12 may be improved.

As such, if the fluorine resin is selected from the ethylene-containing fluorine resin, not only the adhesion with the filling sheet 20 which is usually formed of ethylene vinyl acetate (EVA) but also the interlayer adhesion with the polyester film layer 12 which is formed of the polyethylene terephthalate (PET) film, the polyethylene naphthalate (PEN) film, etc. may be improved.

The solvent is not particularly limited as long as it provides a viscosity suitable for coating by diluting the fluorine resin. For example, the solvent may be one or more organic solvent selected from an alcohol, a glycol, a ketone, a formamide, etc. As specific examples, the solvent may be one or more selected from methanol, ethanol, isopropanol, methylene glycol, ethylene glycol, methyl ethyl ketone (MEK), dimethylformamide (DMF), etc.

Although not being particularly limited thereto, the fluorine resin composition may include the solvent in an amount of 50-300 parts by weight based on 100 parts by weight of the fluorine resin. If the content of the solvent is less than 50 parts by weight, coating performance may be not good because of high viscosity. And, if it exceeds 300 parts by weight, a long time may be required for hardening (drying).

The method and number of coating of the fluorine resin composition for forming the fluorine coating layer 14 are not particularly limited. For example, the fluorine resin composition may be coated one or more times by one or more coating method selected from spin coating, dip coating, bar coating, spray coating, inkjet printing, gravure coating, screen printing, etc.

Fig. 3 schematically shows the configuration of a back sheet 10 according to a second embodiment of the present disclosure.

The back sheet 10 according to the second embodiment of the present disclosure may further include a primer layer 16. Specifically, as shown in Fig. 3, the back sheet 10 according to the second embodiment of the present disclosure has a stacked structure including: a polyester film layer 12; an upper fluorine coating layer 14a coated on an upper surface of the polyester film layer 12; a lower fluorine coating layer 14b coated on a lower surface of the polyester film layer 12; and a primer layer 16 formed on the upper fluorine coating layer 14a.

The primer layer 16 is bonded to a filling sheet 20, i.e. an ethylene vinyl acetate (EVA) sheet, of a solar cell module. The primer layer 16 is for improving adhesion between the upper fluorine coating layer 14a and the filling sheet 20 and is formed by coating an adhesive resin. For example, the primer layer 16 may be formed by coating one or more adhesive resin selected from an acryl resin, a urethane resin, an epoxy resin, an ester resin, etc. And, although not being particularly limited thereto, the primer layer 16 may have a thickness of not greater than 10 $\mu$m, specifically 2-5 $\mu$m.

Fig. 4 schematically shows the configuration of a back sheet 10 according to a third embodiment of the present disclosure.

Specifically, in the embodiments of the present disclosure, a back sheet 10 may include a polyethylene-based film layer 15. Specifically, as shown in Fig. 4, the back sheet 10 according to the third embodiment of the present disclosure may have a stacked structure including: a polyester film layer 12; a fluorine coating layer 14 coated on a lower surface of the polyester film layer 12; and a polyethylene-based film layer 15 formed on an upper surface of the polyester film layer 12. The polyester film layer 12 and the polyethylene-based film layer 15 may be bonded by thermal bonding or using an adhesive. The adhesive is not particularly limited. For example, one or more adhesive selected from an acryl resin, a urethane resin, an epoxy resin, etc. may be used.

The polyethylene-based film layer 15 is formed of a polyethylene-based film. In the embodiments of the present disclosure, the polyethylene-based film is formed from a polyethylene-based resin containing ethylene in the molecule and is not particularly limited as long as it contains ethylene in the molecule. The polyethylene-based resin may be selected from a homopolymer or a copolymer of an ethylene monomer. For example, the copolymer may be a copolymer of an ethylene monomer and a propylene or butylene monomer, etc. Specifically, the polyethylene-based film may be a polyethylene (PE) film or a copolymer film of ethylene and propylene.

The polyethylene-based film layer 15 is bonded with a filling sheet 20, i.e. an ethylene vinyl acetate (EVA) sheet, of a solar cell module. If the back sheet 10 includes the polyethylene-based film layer 15 as in the third embodiment of the present disclosure, a superior adhesive property may be achieved. That is to say, it is possible to achieve not only superior adhesion between the back sheet 10 and the filling sheet 20 but also superior interlayer adhesion of the back sheet 10.

As described above, the filling sheet 20 of the solar cell module may be formed of an ethylene vinyl acetate (EVA) sheet. In this case, since the polyethylene-based film layer 15 contains ethylene, which is one of the monomers constituting the ethylene vinyl acetate (EVA) sheet, it has superior adhesive property with the filling sheet 20. Also, as described above, the polyester film layer 12 may be formed of a polyethylene terephthalate (PET) film or a polyethylene naphthalate (PEN) film. In this case, since the polyethylene-based film layer 15 contains ethylene, which is one of the monomers constituting the polyethylene terephthalate (PET) film or the polyethylene naphthalate (PEN) film, it has superior adhesive property with the polyester film layer 12.

As such, if the back sheet 10 according to the embodiments of the present disclosure includes the polyethylene-based film layer 15 which is bonded to the filling sheet 20 of the solar cell module, i.e. the ethylene vinyl acetate (EVA) sheet, superior adhesion with the filling sheet 20 and superior interlayer adhesion with the polyester film layer 12 may be achieved.

In an exemplary embodiment, the polyethylene-based film layer 15 may include a white and/or inorganic material. Specifically, the polyethylene-based film layer 15 may include a white inorganic material. The white inorganic material is not particularly limited as long as it is a white inorganic material particle. Specifically, one or more selected from titanium dioxide, calcium oxide, magnesium oxide, etc. may be used. More specifically, the white inorganic material includes at least titanium dioxide. That is to say, the white inorganic material may be, for example, titanium dioxide, or a mixture further including one or more selected from calcium oxide, magnesium oxide, etc., in addition to titanium dioxide.

If the polyethylene-based film layer 15 includes the white inorganic material, mechanical strength and photoconversion efficiency of the solar cell may be improved. That is to say, the inorganic material confers mechanical strength to the polyethylene-based film layer 15. Particularly, the white inorganic material may confer reflecting ability to the polyethylene-based film layer 15, so that incident sunlight can be reflected. Accordingly, the amount of light captured by the solar cell C (see Fig. 6) may be increased and photoconversion efficiency may be improved. As described above, the white inorganic material may include titanium dioxide. The titanium dioxide may be advantageous used in the embodiments of the present disclosure since it exhibits very superior mechanical strength, sunlight reflecting ability, etc.

The polyethylene-based film layer 15 may include the white inorganic material in an amount of 2-20 parts by weight based on 100 parts by weight of the polyethylene-based resin. If the content of the white inorganic material is less than 2 parts by weight, the effect of improving mechanical strength, sunlight reflecting ability, etc. may be insufficient. And, if the content of the white inorganic material exceeds 20 parts by weight, mechanical strength (tensile strength) may decrease and cost may increase. In consideration of these factors, the white inorganic material may be included in an amount of more specifically 5-15 parts by weight.

The white inorganic material may have an average particle size not greater than 30 $\mu$m. For example, the white inorganic material may have an average particle size of 0.1-30 $\mu$m. If the average particle size of the white inorganic material is smaller than 0.1 $\mu$m, improvement of sunlight reflecting ability may be slight. And, if it exceeds 30 $\mu$m, adhesive property of the polyethylene-based resin may be negatively affected. More specifically, the white inorganic material may have an average particle size of 2-10 $\mu$m.

The polyethylene-based film layer 15, which includes the white inorganic material, may have a thickness of 30-250 $\mu$m. If the thickness is smaller than 30 $\mu$m, the improvement of sunlight reflecting ability may be insufficient. And, if it exceeds 250 $\mu$m, the flexibility of the back sheet 10 may be negatively affected and cost may increase.

Further, the polyethylene-based film layer 15 is advantageous in the embodiments of the present disclosure in that it improves moisture barrier property. That is to say, the polyethylene-based film layer 15 may increase the moisture barrier property of the back sheet 10 and thus improve durability by lowering moisture permeability.

Fig. 5 schematically shows the configuration of a back sheet 10 according to a fourth embodiment of the present disclosure.

In the fourth embodiment of the present disclosure, the back sheet 10 may further include a silicon oxide layer (e.g., silica) or an aluminum oxide layer (e.g., alumina) between a polyester film layer and a fluorine coating layer. The silicon oxide layer (e.g., silica) or the aluminum oxide layer (e.g., alumina) may also be included between a polyester film layer 12 and a polyethylene-based film layer 15.

Specifically, as shown in Fig. 5, the back sheet according to the fourth embodiment of the present disclosure has a stacked structure including: a polyester film layer 12; a silicon oxide layer 13 formed on a lower surface of the polyester film layer 12; a fluorine coating layer 14 coated on a lower surface of the silicon oxide layer 13; and a polyethylene-based film layer 15 formed on an upper surface of the polyester film layer 12.

If the silicon oxide layer 13 is included between the polyester film layer 12 and the fluorine coating layer 14, the back sheet 10 according to the embodiments of the present disclosure may have improved barrier property and corrosion resistance.

The silicon oxide layer may be formed by a deposition process such as sputtering, CVD, PVD, etc. Also, it may be formed by a wet coating process such as spin coating, dip coating, bar coating, spray coating, inkjet printing, gravure coating, screen printing, etc. Specifically, the silicon oxide layer 13 may have a thickness of 10-500 nm. More specifically, the silicon oxide layer may have a thickness of 50-250 nm. If the thickness of the silicon oxide layer is smaller than 10 nm, barrier property and corrosion resistance may be unsatisfactory. And, if the thickness of the silicon oxide layer exceeds 500 nm, cost may increase or workability may be not good.

A solar cell module according to the embodiments of the present disclosure includes the back sheet 10 according to the embodiments of the present disclosure described above. Fig. 6 schematically shows an exemplary solar cell module according to an embodiment of the present disclosure.

Referring to Fig. 6, a solar cell module according to an exemplary embodiment of the present disclosure includes a transparent member 30, a filling sheet 20, a solar cell C and the back sheet 10 according to the present disclosure described above.

The transparent member 30 protects the upper side of the solar cell C. For the transparent member, a reinforced glass which is advantageous in protection of the solar cell and incidence of light may be used. The filling sheet 20 is the portion where a plurality of electrically connected solar cells C are fixed and charged. As seen from Fig. 6, it may comprise an upper filling sheet 20b and a lower filling sheet 20a. For the filling sheet 20, 20a, 20b, an ethylene vinyl acetate (EVA) sheet may be used.

As shown in Fig. 6, the back sheet 10 is attached to a lower surface of the filling sheet 20, specifically to a lower surface of the lower filling sheet 20a. The back sheet 10 and the lower filling sheet 20a may be bonded by thermal bonding or using an adhesive. The adhesive is not particularly limited. For example, one or more adhesive selected from an acryl resin, a urethane resin, an epoxy resin, etc. may be used. Specifically, the back sheet 10 and the lower filling sheet 20a may be bonded by thermal bonding. In case of the back sheet 10 shown in Fig. 2, the upper fluorine coating layer 14a is attached to the lower filling sheet 20a. In case of the back sheet 10 shown in Fig. 3, the primer layer 16 is formed on the lower filling sheet 20a. And, in case of the back sheet 10 shown in Fig. 4 and Fig. 5, the polyethylene-based film layer 15 is attached to the lower filling sheet 20a. Fig. 6 shows an exemplary solar cell module which is attached to the back sheet 10 shown in Fig. 4.

According to the embodiments of the present disclosure described above, the cost of the back sheet 10 can be reduced. That is to say, since the inexpensive fluorine resin composition in liquid state is coated to form the fluorine coating layer 14, instead of using the expensive fluorine-based film 1 b (e.g., PVDF or PVF), a back sheet 10 having comparable weather resistance can be provided at lower cost.

Further, as described above, if the fluorine coating layer 14 includes the ethylene-containing fluorine resin, adhesion with the filling sheet 20 which is usually formed of ethylene vinyl acetate (EVA), and interlayer adhesion with the polyester film layer 12 such as a polyethylene terephthalate (PET) film or polyethylene naphthalate (PEN) film are improved. In particular, when the polyethylene-based film layer 15 includes a white inorganic material (specifically, titanium dioxide), adhesion with the filling sheet 20 and interlayer adhesion with the polyester film layer 12 are further improved and moisture barrier property are improved. As a result, the durability, mechanical strength and photoconversion efficiency of a solar cell can be improved. In addition, if a silicon oxide layer is included between the polyester film layer 12 and the fluorine coating layer 14, the back sheet 10 for a solar cell module may have improved barrier property and corrosion resistance.

Hereinafter, the present disclosure will be described in detail through examples and a comparative example. However, the following examples are for illustrative purposes only and it will be apparent to those of ordinary skill in the art that the scope of the present disclosure is not limited by the examples.

[Example 1]

10 parts by weight of titanium dioxide ($TiO_2$) having an average particle size of 3 $\mu$m was mixed with 100 parts by weight of polyethylene (PE). The mixture was prepared into a 150-$\mu$m thick white PE film (hereinafter, referred to as 'W-PE film') through biaxial stretching.

Also, a 15-$\mu$m thick fluorine coating layer was formed by coating polytetrafluoroethylene (PTFE) on one surface of a heat-resistant PET film (thickness: 150 $\mu$m). On the other surface, the W-PE film (PE + $TiO_2$) prepared above was attached using an acryl-based adhesive to prepare a back sheet having a stacked structure of W-PE (150 $\mu$m)/heat-resistant PET (150 $\mu$m)/fluorine coating layer (15 $\mu$m).

[Examples 2-4]

10 parts by weight of titanium dioxide ($TiO_2$) having an average particle size of 3 $\mu$m was mixed with 100 parts by weight of polyethylene (PE). The mixture was prepared into a 150-$\mu$m thick white PE film (W-PE film) through biaxial stretching.

Also, a 30-nm, 120-nm or 200-nm thick silica layer was formed on a lower surface of a heat-resistant PET film (thickness: 150 $\mu$m) through deposition and a 15-$\mu$m thick fluorine coating layer was formed by coating polytetrafluoroethylene (PTFE) on a lower surface of the silica layer. On an upper surface of the heat-resistant PET, the W-PE film (PE + $TiO_2$) prepared above was attached using an acryl-based adhesive to prepare a back sheet having a stacked structure of W-PE (150 $\mu$m)/heat-resistant PET (150 $\mu$m)/silica layer/fluorine coating layer (15 $\mu$m). Examples 2-4 are identical in the stacked structure and differ only in the thickness of the silica layer: Example 2 (silica layer thickness: 30 nm), Example 3 (silica layer thickness: 120 nm), Example 4 (silica layer thickness: 200 nm).

[Example 5]

A back sheet having a stacked structure of fluorine coating layer (15 $\mu$m)/heat-resistant PET (250 $\mu$m)/fluorine coating layer (15 $\mu$m) was prepared by coating polytetrafluoroethylene (PTFE) on both surfaces of a heat-resistant PET film (thickness 250 $\mu$m).

[Example 6]

A back sheet having a stacked structure of primer layer (3 $\mu$m)/fluorine coating layer (15 $\mu$m)/heat-resistant PET (250 $\mu$m)/fluorine coating layer (15 $\mu$m) was prepared in the same manner as in Example 5, except for further forming a 3-$\mu$m thick primer layer by coating an acryl-based adhesive on a fluorine coating layer.

[Comparative Example]

As an existing back sheet, a back sheet having a stacked structure of PVDF (30 $\mu$m)/heat-resistant PET (250 $\mu$m)/PVDF (30 $\mu$m) was prepared by attaching a PVDF film (thickness: 30 $\mu$m) on both surfaces of a heat-resistant PET film (thickness: 250 $\mu$m).
The back sheet samples of the examples and the comparative example were subjected to evaluation of physical properties including tensile strength, elongation, interlayer adhesion, adhesion with EVA, moisture permeability and dimensional stability were measured. The result is shown in [Table 1].

(1) Tensile strength and elongation

Each back sheet sample was cut to a size of 15 mm x 15 mm using a cutter bar and then tensile strength and elongation were measured. The tensile strength was measured after adjusting the full scale of the measuring device 20% higher than the tensile strength of the sample.

(2) Interlayer adhesion

The PET film at the end portion of each back sheet sample was slightly peeled and peel strength was measured at a peel angle of 180°. The peel strength (interlayer adhesion) was measured between PVDF and PET (Comparative Example), between W-PE and PET (Example 1-4) and between the fluorine coating layer and PET (Examples 5 and 6).

(3) Adhesion with EVA

Each back sheet sample was attached to an EVA sheet by thermal bonding. The back sheet sample was cut to A4 size and the EVA sheet was cut to a smaller size than the back sheet sample. They were overlapped and bonded by putting in a convection oven at 150 °C for 15 minutes. After taking out of the oven and cooling, followed by cutting to a size of 15 mm x 15 mm, peel strength between the EVA sheet and the back sheet (i.e., adhesion with EVA) was measured.

(4) Moisture permeability

Each back sheet sample was cut to a size of 15 mm x 15 mm using a cutter bar and moisture permeability was measured.

(5) Dimensional stability

Each back sheet sample was cut to a size of 120 mm x 60 mm using a cutter bar and a starting point and a 100-mm point in the transverse direction were marked. After putting the sample in an oven at 150 °C for 30 minutes, the length between the two marked points was measured. Heat-resistant dimensional stability was evaluated according to the following equation.

$$\text{Heat-resistant dimensional stability (\%)} = (t - t_0)/t_0 \times 100$$

(t: initial length (100mm), $t_0$: length after heat treatment)

[Table 1]

| | | Comp. Ex. | Ex. 1 | Ex. 2 | Ex. 3 | Ex. 4 | Ex. 5 | Ex. 6 | Note |
|---|---|---|---|---|---|---|---|---|---|
| <Physical property measurement result> | | | | | | | | | |
| Stacked structure of back sheet | | PVDF(30 μm)/heat-resistant PET (250 μm)/PVDF( 30 μm) | W-PE (150 μm)/heat-resistant PET (150 μm)/fluorine coating (15 μm) | W-PE (150 μm)/heat-resistant PET (150 μm)/silica layer (30 nm)/fluorine coating layer (15 μm) | W-PE (150 μm)/heat-resistant PET (150 μm)/silica layer (120 μm)/fluorine coating layer (15 μm) | W-PE (150 μm)/heat-resistant PET (150 μm)/silica layer (200 nm)/fluorine coating layer (15 μm) | Fluorine coating (15 μm)/heat-resistant PET (250 μm)/fluorine coating (15 μm) | Primer (3 μm)/fluorine coating (15 μm)/heat-resistant PET (250 μm)/fluorine coating (15 μm) | - |
| Tensile strength (kgf/15 mm) | MD | 75 | 60 | 60 | 60 | 60 | 65 | 65 | ASTM D-882 |
| | TD | 65 | 55 | 55 | 55 | 55 | 60 | 60 | |
| Elongation (%) | MD | 300 | 230 | 230 | 230 | 230 | 230 | 230 | ASTM D-882 |
| | TD | 220 | 210 | 210 | 210 | 210 | 200 | 200 | |
| Interlayer adhesion (kgf/15 mm) | | 0.5 (PVDF/PET) | 2.0 (W-PE/PET) | 2.0 (W-PE/PET) | 2.0 (W-PE/PET) | 2.0 (W-PE/PET) | 1.5 (fluorine coating /PET) | 1.5 (fluorine coating /PET) | ASTM D-882 |
| Adhesion with EVA (kgf/15mm) | | 0.5 | unpeeled | unpeeled | unpeeled | unpeeled | 0.8 | 1.0 | ASTM D-882 |
| Moisture permeability (g/m²·day) | | 2.4 | 1.2 | 0.7 | 0.2 | 0.1 | 2.4 | 2.4 | - |
| Dimensional stability (%) | | 0.5 | 0.5 | 0.5 | 0.5 | 0.5 | 0.5 | 0.5 | 150 °C, 30 min |

As seen from [Table 1], the back sheets of Examples 1-6 according to the present disclosure exhibit superior interlayer adhesion and adhesion with EVA as compared to Comparative Example. In particular, Examples 1-4 wherein the W-PE film (PE + TiO$_2$) was used exhibit very superior interlayer adhesion and adhesion with EVA, and superior moisture barrier property with low moisture permeability.

And, the back sheet samples of Examples 1 and 5, and Comparative Example were subjected to reliability (weather resistance) evaluation using an accelerated UV exposure testing instrument. The result is shown in [Table 2]. After exposing each back sheet sample to a UV lamp at 65 W/m$^2$ intensity in the testing instrument for 100, 200 and 500 hours under the condition of 70% RH and 65 °C, ensile strength, elongation, interlayer adhesion and dimensional stability were evaluated as described above.

[Table 2]

| <Reliability evaluation result> | | | | | Initial | 100 hr | 200 hr | 500 hr |
|---|---|---|---|---|---|---|---|---|
| Comparative Example | PVDF (30 μm)/heat-resistant PET (250 μm)/PVDF(30 μm) | Tensile strength (kgf/15 mm) | MD | | 75 | 76 | 74 | 73 |
| | | | TD | | 65 | 65 | 63 | 61 |
| | | Elongation (%) | MD | | 300 | 303 | 300 | 300 |
| | | | TD | | 220 | 225 | 222 | 217 |
| | | Interlayer adhesion (kgf/15mm) | | | 0.5 | 0.5 | 0.5 | 0.3 |
| | | Dimensional stability (%) | | | 0.5 | 0.5 | 0.5 | 0.5 |
| Example 1 | W-PE (150 μm)/heat-resistant PET (150 μm)/fluorine coating (15 μm) | Tensile strength (kgf/15 mm) | MD | | 60 | 59 | 60 | 56 |
| | | | TD | | 55 | 55 | 55 | 53 |
| | | Elongation (%) | MD | | 230 | 232 | 230 | 215 |
| | | | TD | | 210 | 213 | 208 | 205 |
| | | Interlayer adhesion (kgf/15 mm) | | | 2.0 | 2.0 | 2.0 | 2.0 |
| | | Dimensional stability (%) | | | 0.5 | 0.5 | 0.5 | 0.5 |
| Example 5 | Fluorine coating (15 μm)/heat-resistant PET (250 μm)/fluorine coating (15 μm) | Tensile strength (kgf/15mm) | MD | | 65 | 65 | 64 | 62 |
| | | | TD | | 60 | 60 | 60 | 58 |
| | | Elongation (%) | MD | | 230 | 230 | 228 | 230 |
| | | | TD | | 200 | 200 | 200 | 198 |
| | | Interlayer adhesion (kgf/15 mm) | | | 1.5 | 1.5 | 1.5 | 1.5 |
| | | Dimensional stability (%) | | | 0.5 | 0.5 | 0.5 | 0.5 |

As seen from [Table 2], superior reliability (weather resistance) was observed even after exposure to UV for a long time. In particular, the back sheet samples according to the present disclosure retained the initial interlayer adhesion even after exposure to UV for 500 hours.

[Table 3] shows a result of physical property evaluation depending on the content of titanium dioxide (TiO$_2$). Specifically, white PE films (W-PE films) were prepared in the same manner as in Example 1 with different titanium dioxide (TiO$_2$) contents, and adhesion with the EVA sheet and moisture permeability of each back sheet sample were evaluated as described above. The result is shown in [Table 3].

[Table 3]

| <Physical property measurement result depending on $TiO_2$ content> | | | | | | |
|---|---|---|---|---|---|---|
| | Comparative Example | Example 1-1 | Example 1-2 | Example 1 | Example 1-3 | Example 1-4 |
| $TiO_2$ content (parts by weight) | - | 2 | 6 | 10 | 14 | 18 |
| Tensile strength (kgf/15 mm) | 6.8 | 7.0 | 7.8 | 8.2 | 8.5 | 8.3 |
| Elongation (%) | 1530 | 1470 | 1360 | 1150 | 880 | 600 |

Examples 1-1 and 1-4 are comparative examples.

As seen from [Table 3], tensile strength and elongation varied depending on the titanium dioxide ($TiO_2$) content. The tensile strength of Examples was higher than that of Comparative Example when the titanium dioxide ($TiO_2$) content was 2 parts by weight or above. The tensile strength increased with the titanium dioxide ($TiO_2$) content but decreased when the content was above 15 parts by weight (18 parts by weight, Example 1-4). Accordingly, when considering tensile strength and elongation, a desirable titanium dioxide ($TiO_2$) content is 5-15 parts by weight.

[Industrial Applicability]

The present disclosure provides a back sheet for a solar cell module that can be provided at low cost and has excellent adhesive property, moisture barrier property, etc., and a solar cell module including same.

**Claims**

1. A back sheet for solar cell module comprising:

   a polyester film layer; and
   a fluorine coating layer coated on at least one surface of the polyester film layer,
   a polyethylene-based film layer formed on an upper surface of the polyester film layer and attached to an ethylene vinyl acetate (EVA) sheet of a solar cell module,
   wherein the polyethylene-based film layer comprises a white inorganic material,
   wherein the polyethylene-based film layer comprises 5-15 parts by weight of a white inorganic material based on 100 parts by weight of a polyethylene-based resin,
   wherein the polyethylene-based film layer is a polyethylene (PE) film or a copolymer film of ethylene and propylene,
   wherein the white inorganic material has an average particle size of 0.1-30 $\mu$m.

2. The back sheet for solar cell module according to claim 1, wherein the white inorganic material comprises titanium dioxide.

3. The back sheet for solar cell module according to claim 1 or 2, wherein the polyethylene-based film layer comprises a white inorganic material and has a thickness of 30-250 $\mu$m.

4. The back sheet for solar cell module according to any one of claims 1 to 3, wherein the fluorine coating layer comprises an ethylene-containing fluorine resin.

5. The back sheet for solar cell module according to any one of claims 1 to 4, wherein the fluorine coating layer has a thickness of 5-30 $\mu$m.

6. The back sheet for solar cell module according to any one of claims 1 to 5, which further comprises a silicon oxide layer between the polyester film layer and the fluorine coating layer.

7. The back sheet for solar cell module according to any one of claims 1 to 6, wherein the back sheet for solar cell module comprises:

a polyester film layer;
a silicon oxide layer formed on a lower surface of the polyester film layer;
a fluorine coating layer coated on a lower surface of the silicon oxide layer; and
a polyethylene-based film layer formed on an upper surface of the polyester film layer and attached to an ethylene vinyl acetate (EVA) sheet of a solar cell module,

wherein the polyethylene-based film layer comprises a white inorganic material,
wherein the polyethylene-based film layer comprises 5-15 parts by weight of a white inorganic material based on 100 parts by weight of a polyethylene-based resin,
wherein the polyethylene-based film layer is a polyethylene (PE) film or a copolymer film of ethylene and propylene,
wherein the white inorganic material has an average particle size of 0.1-30 $\mu$m.

8. The back sheet for solar cell module according to any one of claims 1 to 7, wherein a silicon oxide layer having a thickness of 10-500 nm is deposited on at least one surface of the polyester film layer.


## Patentansprüche

1. Rückseitenfolie für ein Solarzellenmodul umfassend:

eine Polyesterfolienschicht; und
eine Fluordeckschicht, die auf zumindest eine Oberfläche der Polyesterfolienschicht aufgetragen ist,
eine Polyethylen-basierte Folienschicht, die auf einer oberen Oberfläche der Polyesterfolienschicht gebildet ist und an einer Ethylenvinylacetat (EVA)-Schicht eines Solarzellenmoduls angehaftet ist,
wobei die Polyethylen-basierte Folienschicht ein weißes anorganisches Material umfasst,
wobei die Polyethylen-basierte Folienschicht 5-15 Gewichtsteile eines weißen anorganischen Materials, bezogen auf 100 Gewichtsteile eines Polyethylen-basierten Harzes, umfasst,
wobei die Polyethylen-basierte Folienschicht eine Polyethylen (PE)-Folie oder eine Copolymerfolie aus Ethylen und Propylen ist,
wobei das weiße anorganische Material eine durchschnittliche Partikelgröße von 0,1-30 $\mu$m aufweist.

2. Rückseitenfolie für ein Solarzellenmodul nach Anspruch 1, wobei das weiße anorganische Material Titandioxid umfasst.

3. Rückseitenfolie für ein Solarzellenmodul nach Anspruch 1 oder 2, wobei die Polyethylen-basierte Folienschicht ein weißes anorganisches Material umfasst und eine Dicke von 30-250 $\mu$m aufweist.

4. Rückseitenfolie für ein Solarzellenmodul nach einem der Ansprüche 1 bis 3, wobei die Fluordeckschicht ein ethylenhaltiges Flourharz umfasst.

5. Rückseitenfolie für ein Solarzellenmodul nach einem der Ansprüche 1 bis 4, wobei die Fluordeckschicht eine Dicke von 5-30 $\mu$m aufweist.

6. Rückseitenfolie für ein Solarzellenmodul nach einem der Ansprüche 1 bis 5, welche ferner eine Siliziumoxidschicht zwischen der Polyesterfolienschicht und der Fluordeckschicht umfasst.

7. Rückseitenfolie für ein Solarzellenmodul nach einem der Ansprüche 1 bis 6, wobei die Rückseitenfolie für ein Solarzellenmodul umfasst:

eine Polyesterfolienschicht;
eine Siliziumoxidschicht, die auf einer unteren Oberfläche der Polyesterfolienschicht gebildet ist;
eine Fluordeckschicht, die auf eine untere Oberfläche der Siliziumoxidschicht aufgetragen ist; und
eine Polyethylen-basierte Folienschicht, die auf einer oberen Oberfläche der Polyesterfolienschicht gebildet ist und an einer Ethylenvinylacetat (EVA)-Schicht eines Solarzellenmoduls angehaftet ist,

wobei die Polyethylen-basierte Folienschicht ein weißes anorganisches Material umfasst,
wobei die Polyethylen-basierte Folienschicht 5-15 Gewichtsteile eines weißen anorganischen Materials, bezogen auf 100 Gewichtsteile eines Polyethylen-basierten Harzes, umfasst,

wobei die Polyethylen-basierte Folienschicht eine Polyethylen (PE)-Folie oder eine Copolymerfolie aus Ethylen und Propylen ist,

wobei das weiße anorganische Material eine durchschnittliche Partikelgröße von 0,1-30 μm aufweist.

8. Rückseitenfolie für ein Solarzellenmodul nach einem der Ansprüche 1 bis 7, wobei eine Siliziumoxidschicht mit einer Dicke von 10-500 nm auf zumindest einer Oberfläche der Polyesterfolienschicht aufgetragen ist.


**Revendications**

1. Couche arrière pour module de cellules solaires, comprenant:

   une couche de film de polyester; et
   une couche de revêtement fluoré revêtue sur au moins une surface de la couche de film de polyester,
   une couche de film à base de polyéthylène formée sur une surface supérieure de la couche de film de polyester et fixée à une couche d'éthylène-acétate de vinyle (EVA) d'un module de cellules solaires,
   ladite couche de film à base de polyéthylène comprenant un matériau inorganique blanc,
   ladite couche de film à base de polyéthylène comprenant entre 5 et 15 parties en poids d'un matériau inorganique blanc sur la base de 100 parties en poids d'une résine à base de polyéthylène,
   ladite couche de film à base de polyéthylène étant un polyéthylène (PE) ou un film copolymère d'éthylène et de propylène,
   ledit matériau inorganique blanc présentant une taille moyenne de particules comprise entre 0,1 et 30 μm.

2. Couche arrière pour module de cellules solaires selon la revendication 1, dans laquelle le matériau inorganique blanc comprend du dioxyde de titane.

3. Couche arrière pour module de cellules solaires selon la revendication 1 ou 2, dans laquelle la couche de film à base de polyéthylène comprend un matériau inorganique blanc et présente une épaisseur comprise entre 30 et 250 μm.

4. Couche arrière pour module de cellules solaires selon l'une quelconque des revendications 1 à 3, dans laquelle la couche de revêtement fluoré comprend une résine fluorée contenant de l'éthylène.

5. Couche arrière pour module de cellules solaires selon l'une quelconque des revendications 1 à 4, dans laquelle la couche de revêtement fluoré présente une épaisseur comprise entre 5 et 30 μm.

6. Couche arrière pour module de cellules solaires selon l'une quelconque des revendications 1 à 5, qui comprend en outre une couche d'oxyde de silicium située entre la couche de film de polyester et la couche de revêtement fluoré.

7. Couche arrière pour module de cellules solaires selon l'une quelconque des revendications 1 à 6, dans laquelle la couche arrière pour module de cellules solaires comprend:

   une couche de film de polyester;
   une couche d'oxyde de silicium formée sur une surface inférieure de la couche de film de polyester;
   une couche de revêtement fluoré revêtue sur une surface inférieure de la couche d'oxyde de silicium; et
   une couche de film à base de polyéthylène formée sur une surface supérieure de la couche de film de polyester et fixée à une couche d'éthylène-acétate de vinyle (EVA) d'un module de cellules solaires,

   ladite couche de film à base de polyéthylène comprenant un matériau inorganique blanc,
   ladite couche de film à base de polyéthylène comprenant entre 5 et 15 parties en poids d'un matériau inorganique blanc sur la base de 100 parties en poids d'une résine à base de polyéthylène,
   ladite couche de film à base de polyéthylène est un polyéthylène (PE) ou un film copolymère d'éthylène et de propylène,
   ledit matériau inorganique blanc présentant une taille moyenne de particules comprise entre 0,1 et 30 μm.

8. Couche arrière pour module de cellules solaires selon l'une quelconque des revendications 1 à 7, dans laquelle une couche d'oxyde de silicium ayant une épaisseur comprise entre 10 et 500 nm est déposée sur au moins une surface de la couche de film de polyester.

【Fig. 1】

【Fig. 2】

10

14(14a)

12

14(14b)

【Fig. 3】

10

16

14(14a)

12

14(14b)

【Fig. 4】

【Fig. 5】

【Fig. 6】